Europäisches Patentamt

European Patent Office

Office européen des brevets

(11) Publication number: **0 200 304 B1**

(12) **EUROPEAN PATENT SPECIFICATION**

(45) Date of publication of patent specification: **29.05.91**    (51) Int. Cl.⁵: **H03H 3/08, H03H 9/02**

(21) Application number: **86301324.9**

(22) Date of filing: **24.02.86**

(54) Saw devices including resistive films.

(30) Priority: **29.03.85 CA 477949**

(43) Date of publication of application:
**10.12.86 Bulletin 86/45**

(45) Publication of the grant of the patent:
**29.05.91 Bulletin 91/22**

(84) Designated Contracting States:
**AT CH DE FR GB LI NL SE**

(56) References cited:
**FR-A- 2 390 830
US-A- 3 978 436
US-A- 4 472 694**

**PATENT ABSTRACTS OF JAPAN, vol. 8, no.
149 (E-255)[1586], 12th July 1984; & JP-A-59
55 615 (HITACHI SEISAKUSHO K.K.)
30-03-1984**

(73) Proprietor: **NORTHERN TELECOM LIMITED
600 de la Gauchetiere Street West
Montreal Quebec H3B 4N7(CA)**

(72) Inventor: **Este, Grantley Oliver
132 McCooeye Lane
Stittsville Ontario K0A 3G0(CA)**
Inventor: **Suthers, Mark Spencer
R.R. No. 1
Lanark Ontario K0G 1K0(CA)**
Inventor: **Streater, Richard William
10 Shoreham Avenue
Nepean Ontario K2G 3T7(CA)**
Inventor: **MacLaurin, Blair Kenneth
43 Cramer Drive
Nepean Ontario K2H 5X6(CA)**

(74) Representative: **Crawford, Andrew Birkby et al
A.A. THORNTON & CO. Northumberland
House 303-306 High Holborn
London WC1V 7LE(GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

## Description

This invention relates to SAW (surface acoustic wave) devices, and is particularly concerned with an improved method of producing SAW devices including surface acoustic wave absorbers, and with improved SAW devices which may be produced by this method.

It is well known to apply acoustic absorber to the surface of the substrate of a SAW device between the back edges of the IDTs (inter-digital transducers) and the edges of the substrate in order to attenuate undesired surface acoustic waves which would otherwise be reflected at the substrate edges and interfere with the desired waves, seriously degrading the performance of the SAW device. The acoustic absorber is generally a viscous material, such as silicon rubber or a viscous epoxy which is applied after formation of the IDTs on the substrate. This is an inconvenience during the manufacture of SAW devices, and the boundary of the acoustic absorber may itself give rise to an undesired reflected surface acoustic wave. Furthermore, the acoustic absorber is frequently an organic material which can produce problems due to outgassing over a period of time.

It is also known to cut the substrate edges at angles so that reflected waves are not directed back into the region of the IDTs. This again is an inconvenience during manufacture of SAW devices.

Japanese patent publication No. 59-55615 dated March 30, 1984 in the name of Hitachi Seisakusho K.K. discloses a SAW device in which, in order to reduce the time during which in manufacture the substrate surface is exposed to ionized particles, a silicon layer is provided on the substrate. The silicon layer may remain on the substrate underlying the aluminum conductors of the IDTs, but is removed, by sputter etching, from all other parts of the substrate surface.

An object of this invention is to provide an improved method of producing SAW devices, and to provide an improved SAW device.

According to one aspect of this invention there is provided a method of producing a SAW (surface acoustic wave) device comprising the steps of: forming a conductively resistive film on a surface of a substrate of piezo-electric material; and forming at least one IDT (inter-digital transducer) for the SAW device on the film; the film being formed on the substrate surface with at least one area defining a surface acoustic wave absorber region adjacent to the IDT, the film constituting a surface acoustic wave absorber in this region.

Thus the or each IDT is formed on a conductively resistive film on the substrate surface; it has been found that the film improves adhesion of the IDT to the substrate and facilitates production of the SAW device without detracting from the performance of the SAW device.

The film can not be present in areas where it is desired to propagate surface acoustic waves because the film acts to attenuate such waves. Accordingly, the resistive film can be formed on the substrate surface with the pattern of each IDT to be formed thereon.

Preferably, however, the film is formed on substantially all of said surface, the method further including the step of removing part of the film after forming the IDT. The film in this case facilitates production of the SAW device by shorting out charges which can occur due to the piezo-electric nature of the substrate.

The film is preferably formed, in each area defining a surface acoustic wave absorber region adjacent to an IDT, with a substantially linear tapered edge adjacent to the IDT, this edge serving to reduce surface acoustic wave reflections at the boundary of the surface acoustic wave absorber region.

The film is conveniently a doped silicon film having a thickness of about 100 Angstrom units, to provide a sheet resistivity of at least about 0.5Mohm/sq., which film may be formed by sputtering silicon onto the surface of the substrate, which is conveniently of lithium niobate. The step of removing part of the silicon film after forming the IDT preferably comprises etching the silicon film for example using a carbon tetrafluoride and oxygen plasma etch. The step of forming the IDT preferably comprises evaporating aluminum onto the silicon film in the pattern of the IDT; the aluminum IDT pattern protects the underlying silicon film from the plasma etch.

According to another aspect this invention provides a SAW (surface acoustic wave) device comprising at least one IDT (inter-digital transducer) on a conductively resistive film, having substantially the same pattern as the IDT, on a surface of a substrate of piezo-electric material, and a conductively resistive film on the substrate surface constituting a surface acoustic wave absorber in a region adjacent to the IDT.

Advantageously the film constituting the surface acoustic wave absorber and the film having the IDT thereon are films of substantially the same material and thickness, both films for example comprising amorphous doped silicon with a sheet resistivity of at least about 0.5Mohm/sq.

Preferably the film constituting the surface acoustic wave absorber has a substantially linear tapered edge adjacent to the IDT pattern and extends to a back edge of the substrate.

The invention will be further understood from the following description with reference to the accompanying drawings, in which:

Fig. 1 schematically illustrates a SAW device in accordance with an embodiment of the invention;

Fig. 2 is a schematic sectional illustration of the form of part of the SAW device of Fig. 1; and

Fig. 3 is a flow chart showing steps in a method of producing a SAW device in accordance with the invention.

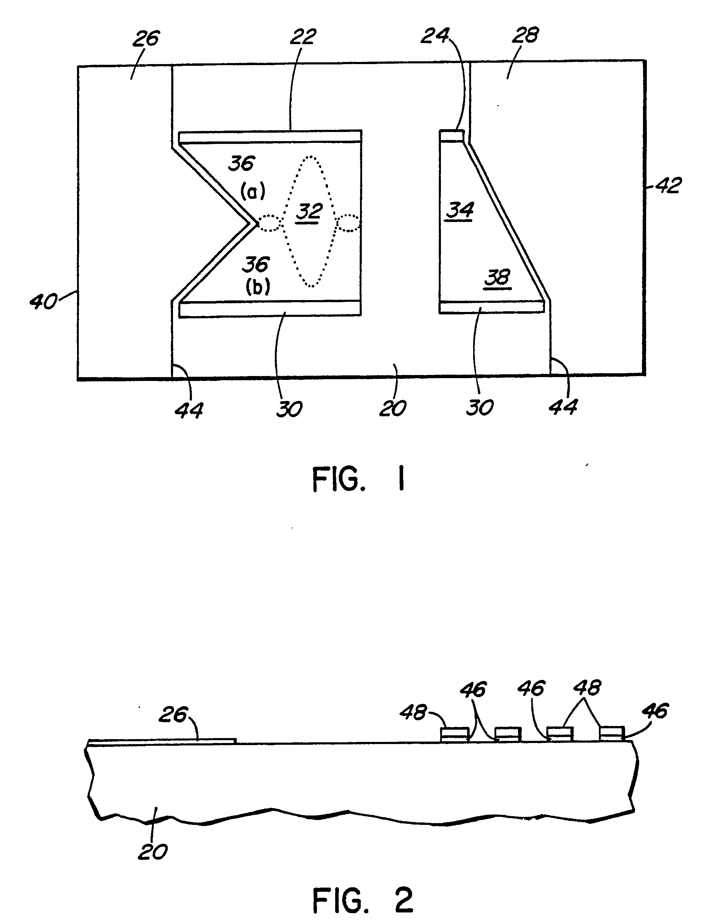

Referring to Fig. 1, there is illustrated a SAW device which comprises a lithium niobate ($LiNbO_3$) substrate 20 on which there are formed two IDTs 22, 24, and surface acoustic wave absorber regions 26, 28. The IDTs 22, 24 serve for transducing a surface acoustic wave which is propagated therebetween, and to this end each IDT comprises conductive rails 30 between which are arranged interdigital fingers of which for the sake of clarity only the outline is shown. By way of example, it is observed that the IDT 22 may be an apodized IDT having an apodization pattern as illustrated in Fig. 1 in an active region 32 thereof, and the IDT 24 may be a non-apodized IDT having an active region 34, the IDTs serving respectively as the input and output transducers of a bandpass filter.

In addition to its active region 32 or 34, each IDT 22 or 24 includes a reflection-suppressing region 36 or 38 respectively adjacent the back edge of the active region. In each reflection-suppressing region fingers connected to the rails 30 are of successively decreasing length to define a linearly tapering back edge of each IDT. The fingers in these regions are spaced apart with a pitch of lambda/4, where lambda is the wavelength of the surface acoustic wave to be propagated, so that they suppress reflections at the back edges of the IDTs. The reflection-suppression region 36 of IDT 22 is split into two halves (a) and (b) which taper from a central gap in the last fingers of the active region 32 of this IDT.

As is well known, the IDTs 22 and 24 are bidirectional devices which transduce not only surface acoustic waves propagating in the desired direction to or from the other IDT, but also waves propagating to or from the edges 40 and 42 of the substrate 20. The surface acoustic wave absorber regions 26 and 28 serve to attenuate such undesired waves to such an extent that waves reflected at these edges 40 and 42 have a negligible effect upon the IDTs and do not degrade the performance of the SAW device. For example, as described below each surface acoustic wave absorber region may provide an attenuation of 0.5dB/wavelength and may be at least 80lambda long in the direction of propagation of surface acoustic waves, to provide a total attenuation of at least 80dB for waves reflected at the edges 40 and 42.

In order to suppress any possible wave reflection at the front edge of each surface acoustic wave absorber region 26 or 28, as illustrated in Fig. 1 this is linearly tapered to complement the shape of the back edge of the adjacent reflection-suppressing region 36 or 38. This taper may be smooth and continuous as indicated in Fig. 1, or it may be linearly stepped with steps each having a width of lambda/4 in order to complement precisely the shape of the adjacent reflection-suppressing region. Reflections from adjacent such steps are out of phase with one another due to the lambda/4 pitch of the steps, whereby they cancel one another. The same effect occurs with a linearly smooth and continuous taper, whereby in either case there is negligible reflection at the boundary of the acoustic absorber region 26 or 28.

The above comments apply across the width of the aperture A of the IDTs; outside of this aperture there is substantially no surface acoustic wave so that there is little need for either reflection-suppressing fingers or a tapered surface acoustic wave absorber boundary. As shown in Fig. 1, the surface acoustic wave absorber regions have perpendicular boundaries 44 outside the aperture A.

In contrast to known SAW devices using materials such as viscous epoxy as surface acoustic wave absorbers, in accordance with this embodiment of the invention the surface acoustic wave absorber regions 26 and 28 are electro-acoustic absorber regions which are constituted by a thin resistive film on the substrate surface. In this embodiment of the invention this is a thin film of amorphous doped silicon having a thickness of about 100 Angstrom units (10nm) and a sheet resistivity of at least about 0.5Mohm/sq. Such a film provides the attenuation of about 0.5dB/wavelength mentioned above. In this respect the electro-acoustic absorber is an absorber which absorbs the surface acoustic wave by coupling the electric fields associated with the wave to carriers in the resistive film constituting the absorber.

The silicon film is provided not only to constitute the electro-acoustic absorber regions 26 and 28; it also underlies the conductive rails and fingers of the IDTs 22 and 24, thereby enhancing the adhesion of these to the substrate. This is shown in detail in the sectional illustration in Fig. 2.

As shown in Fig. 2, the substrate 20 has formed thereon the thin silicon film as described above, which forms not only an electro-acoustic absorber region, e.g. 26, but also an adhesion-enhancing film 46 under each of the fingers 48 of the adjacent IDT. The film 46 similarly extends under the conductive rails 30. As the fingers 48 and rails 30 are themselves conductive, they electrically short the resistive film underlying them so that this has no disadvantageous effect in the regions of the IDTs.

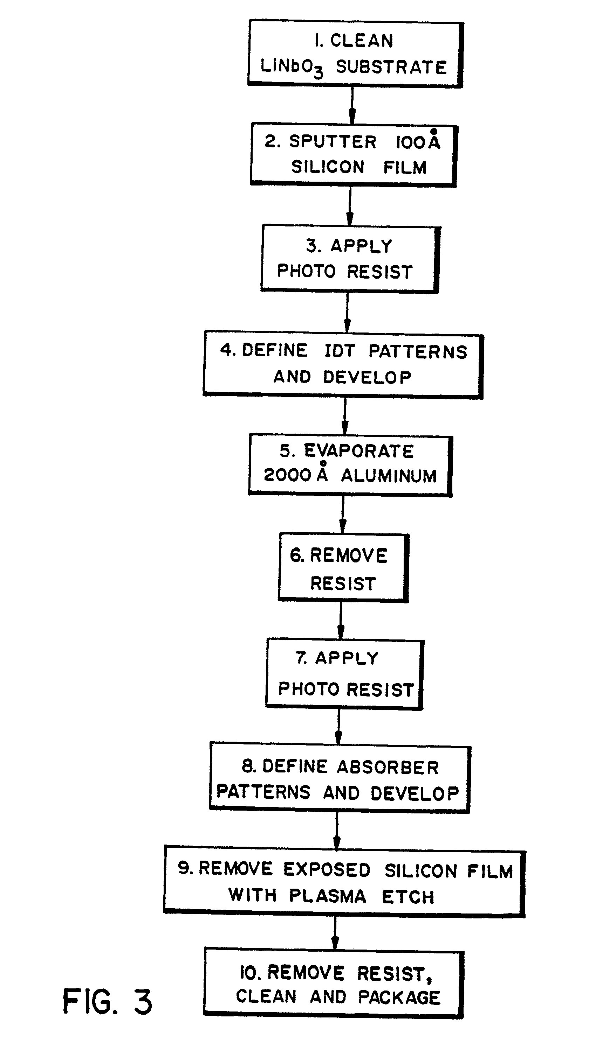

Fig. 3 shows a flow chart of a sequence of ten steps numbered 1 to 10 used for producing SAW devices as described above with reference to Figs. 1 and 2. Initially (step 1), the lithium niobate substrate is cleaned in known manner. The amorphous doped silicon film is then (step 2) sputtered onto the surface of the substrate to the desired thickness of about 100 Angstrom units. This thickness determines the sheet resistivity and the absorption effect of the absorbing regions 26 and 28, it having been determined experimentally that thicknesses of this order provide sheet resistivities of at least about 0.5Mohm/sq and correspond to a maximum point in a graph of absorption against thickness or sheet resistivity at about 0.5dB/wavelength.

In step 3, photoresist is applied over the silicon film, and in step 4 the desired pattern of the IDTs' fingers and conductive rails is defined through a printing mask and the photoresist is developed in known manner. In step 6 the IDTs are formed in this desired pattern by evaporating aluminum, onto the silicon film in the areas where this is exposed by the developed photoresist, to a desired thickness of typically 2000 Angstrom units (200nm). As already indicated, the aluminum adheres more readily to the silicon film than it does directly to a lithium niobate substrate, whereby this step is more readily achieved with improved adhesion of the IDTs.

In step 6 the remaining photoresist and unwanted aluminum is removed in conventional manner, and in step 7 a new layer of photoresist is applied over the silicon film and aluminum IDT patterns. The desired patterns of the silicon film electro-acoustic absorber regions at the ends of the SAW device substrate are then defined in step 8 using a printing mask, and the photoresist is developed.

In step 9, the silicon film is removed from all of the areas where it is exposed using a carbon tetrafluoride and oxygen plasma etch. The silicon film remains in those regions where it is protected by the photoresist (i.e. in the electro-acoustic absorber regions) and in those regions where it is overlaid by the aluminum IDTs. In the final step 10, the remaining photoresist is removed and conventional cleaning and packaging processes are performed. Where many SAW devices are simultaneously manufactured on a single wafer, this step 10 also includes the process of dividing the wafer into the individual SAW devices in known manner.

The manufacture of SAW devices in the prior art involves a further disadvantage in that the lithium niobate substrate is strongly piezo-electric and consequently frequently creates surface charges which electrostatically clamp it to the photo mask plate when the IDT patterns are being defined. In the method described above the silicon film provides the further advantage that it effectively shorts such charges, thereby removing this disadvantage in using photo mask plates in steps 4 and 8.

Although a particular embodiment of the invention has been described in detail above, it should be appreciated that the invention is not limited to this, but is applicable to numerous variations of this. For example, the resistive film may be of different materials and thicknesses; in particular it may be of germanium or tellurium, or it may be in the form of a metal film grid providing the desired sheet resistivity. Similarly the substrate may be of a suitable material other than lithium niobate, and the IDTs may be a suitable material other than aluminum, for example gold.

In addition, the electro-acoustic absorber regions and IDTs may have different shapes and configurations either with or without reflection-suppressing features. In particular, it is observed that the front edges of the electro-acoustic absorber regions need not be continuously substantially linearly tapered across the entire width of the IDT aperture, but instead may have a sawtooth or serrated form with the same reflection-suppressing result. Furthermore, other sequences of steps may be used in forming the SAW devices.

These and many other modifications, variations and adaptations may be made without departing from the scope of the invention as defined in the claims.

## Claims

1. A method of producing a SAW (surface acoustic wave) device comprising the steps of:

    forming a conductively resistive film on a surface of a substrate of piezo-electric material; and

    forming at least one IDT (inter-digital transducer) for the SAW device on the film;

    the film being formed on the substrate surface with at least one area defining a surface acoustic wave absorber region adjacent to the IDT, the film constituting a surface acoustic wave absorber in this region.

2. A method as claimed in claim 1 wherein the film is formed on substantially all of said surface, the method further including the step of removing part of the film after forming the IDT.

3. A method as claimed in claim 1 wherein the film is formed on the substrate surface with the pattern of each IDT to be formed thereon.

4. A method as claimed in claim 1, 2, or 3 wherein the film is formed, in each area defining a surface acoustic wave absorber region adjacent to an IDT, with a substantially linear tapered edge adjacent to the IDT.

5. A method as claimed in any of claims 1 to 4 wherein the film comprises a silicon film having a sheet resistivity of at least about 0.5Mohm/sq.

6. A method as claimed in claims 2 and 5 wherein the step of removing part of the silicon film after forming the IDT comprises etching the silicon film.

7. A method as claimed in claim 6 wherein the step of forming the IDT comprises evaporating aluminum onto the silicon film in the pattern of the IDT.

8. A method as claimed in any of claims 5 to 7 wherein the silicon film is formed on the substrate surface by sputtering.

9. A method as claimed in any of claims 1 to 8 wherein the substrate material is lithium niobate.

10. A SAW (surface acoustic wave) device comprising at least one IDT (inter-digital transducer) (22, 24) on a conductively resistive film (46), having substantially the same pattern as the IDT, on a surface of a substrate (20) of piezo-electric material, and a conductively resistive film (26, 28) on the substrate surface constituting a surface acoustic wave absorber in a region adjacent to the IDT.

11. A SAW device as claimed in claim 10 wherein the film (26, 28) constituting the surface acoustic wave absorber and the film (46) having the IDT (22, 24) thereon are films of substantially the same material and thickness.

12. A SAW device as claimed in claim 10 or 11 wherein the film (26, 28) constituting the surface acoustic wave absorber has a substantially linear tapered edge adjacent to the IDT pattern.

13. A SAW device as claimed in any of claims 10 to 12 wherein the film (26, 28) constituting the surface acoustic wave absorber extends from adjacent to the IDT (22, 24) pattern to an edge (40, 42) of the substrate.

14. A SAW device as claimed in any of claims 10 to 13 wherein each of said films comprises an amorphous silicon film.

15. A SAW device as claimed in any of claims 10 to 14 wherein each of said films has a sheet resistivity of at least about 0.5Mohm/sq.

16. A SAW device as claimed in any of claims 10 to 15 wherein the substrate material is lithium niobate.

## Revendications

1. Méthode pour produire un dispositif à OAS (ondes acoustiques de surface) comprenant les étapes consistant à :
   former un film résistif au point de vue conductivité sur une surface d'un substrat d'un matériau piézoélectrique; et à
   former au moins un TID (transducteur interdigital) pour un dispositif à OAS sur le film:
   le film étant formé sur la surface du substrat avec au moins une zone définissant une région absorbant les ondes acoustiques de surface jouxtant le TID, le film constituant un absorbeur des ondes acoustiques de surface dans cette région.

2. Méthode selon la revendication 1, où le film est formé sensiblement sur la totalité de ladite surface, la méthode comprenant en outre l'étape consistant à enlever une partie du film après la formation du TID.

3. Méthode selon la revendication 1, où le film est formé sur la surface du substrat avec le motif de chaque TID à former par-dessus.

4. Méthode selon la revendication 1, 2 ou 3, où le film est formé dans chaque zone définissant une région absorbant les ondes acoustiques de surface jouxtant un TID, avec un bord en biais sensiblement linéaire, jouxtant le TID.

5. Méthode selon l'une quelconque des revendications 1 à 4, où le film comprend un film de silicium ayant une résistivité de couche d'au moins environ 0,5 Mohm/carré.

6. Méthode selon les revendications 2 et 5, où l'étape consistant à enlever une partie du film de silicium après la formation du TID comprend une attaque du film de silicium.

7. Méthode selon la revendication 6, où l'étape consistant à former le TID comprend d'évaporer de l'aluminium sur le film de silicium suivant le motif du TID.

8. Méthode selon l'une quelconque des revendications 5 à 7, où le film de silicium est formé sur la surface du substrat par pulvérisation.

9. Méthode selon l'une quelconque des revendications 1 à 8, où le matériau du substrat est le niobiate de lithium.

10. Dispositif à OAS (ondes acoustiques de surface) comprenant au moins un TID (transducteur interdigital) (22, 24) sur un film résistif au point de vue conductivité (46) présentant sensiblement le même motif que le TID sur une surface d'un substrat (20) de matériau piézoélectrique et un film résistif (26, 28) au point de vue conductivité sur la surface du substrat constituant un absorbeur des ondes acoustiques de surface dans une région jouxtant le TID.

11. Dispositif d'OAS selon la revendication 10, où le film (26, 28) constituant l'absorbeur des ondes acoustiques de surface et le film (46) portant le TID (22, 24), sont des films constitués sensiblement du même matériau et ayant sensiblement la même épaisseur.

12. Dispositif d'OAS selon la revendication 10 ou 11, où le film (26, 28) constituant l'absorbeur des ondes acoustiques de surface a un bord en biais sensiblement linéaire, jouxtant le motif du TID.

13. Dispositif d'OAS selon l'une quelconque des revendications 10 à 12, où le film (26, 28) constituant l'absorbeur des ondes acoustiques de surface s'étend depuis le motif du TID (22, 24) jusqu'à un bord (40, 42) du substrat.

14. Dispositif à OAS selon l'une quelconque des revendications 10 à 13, où chacun desdits films comprend un film de silicium amorphe.

15. Dispositif à OAS selon l'une quelconque des revendications 10 à 14, où chacun desdits films a une résistivité de couche au moins d'environ 0,5 Mohm/carré.

16. Dispositif à OAS selon l'une quelconque des revendications 10 à 15, où le matériau du substrat est du niobiate de lithium.

**Ansprüche**

1. Verfahren zu Herstellung eines SAW (surface acoustic wave = Akustik-Oberflächenwellen)-Bauelementes mit den Schritten:

es wird eine leitende Widerstands-Schicht auf einer Oberfläche eines Substrats aus piezoelektrischem Material ausgebildet; und

es wird mindestens ein IDT (inter-digital transducer = verzahnter Wandler) für das SAW-Bauelement an der Schicht ausgebildet;

wobei die Schicht an der Substratfläche mit mindestens einem einen dem IDT benachbarten Absorberbereich für akustische Oberflächenwellen bestimmenden Flächenabschnitt ausgebildet wird und die Schicht in diesem Bereich einen Absorber für Oberflächen-Akustikwellen bildet.

2. Verfahren nach Anspruch 1, bei dem die Schicht auf im wesentlichen der ganzen Oberfläche ausgebildet wird und weiter ein Teil der Schicht nach dem Ausbilden des IDT entfernt wird.

3. Verfahren nach Anspruch 1, bei dem die Schicht auf der Substrat-Oberfläche ausgebildet wird, wobei das Muster jedes IDT daran auszubilden ist.

4. Verfahren nach den Ansprüchen 1, 2 oder 3, bei dem die Schicht in jedem einen Absorberbereich für Akustik-Oberflächenwellen benachbart zu einem IDT bestimmenden Flächenabschnitt mit einer sich dem IDT benachbart im wesentlichen linear verjüngenden Kante ausgebildet wird.

5. Verfahren nach einem der Ansprüche 1 bis 4, bei dem die Schicht eine Siliciumschicht mit einem Schichtwiderstandswert von mindestens 0,5 M$\Omega$/Quadr. umfaßt.

6. Verfahren nach Ansprüchen 2 und 5, bei dem das Entfernen eines Teils der Siliciumschicht nach dem Ausbilden des IDT Ätzen der Siliciumschicht umfaßt.

7. Verfahren nach Anspruch 6, bei dem das Ausbilden des IDT das Aufdampfen von Aluminium auf die Siliciumschicht in dem Umriß des IDT umfaßt.

8. Verfahren nach einem der Ansprüche 5 bis 7, bei dem die Siliciumschicht an der Substrat-Oberfläche durch Katodenzerstäubung ausgebildet wird.

9. Verfahren nach einem der Ansprüche 1 bis 8, bei dem das Substrat-Material Lithium-Niobat ist.

10. SAW (surface acoustic wave = Akustik-Oberflächenwellen)-Bauelement mit mindestens einem IDT (inter-digital transducer = verzahnter Wandler) (22,24) an einer leitenden Widerstandsschicht (46) mit im wesentlichen gleichem Umriß wie dem des IDT auf einem Substrat (20) aus piezoelektrischem Material und einer einen Akustik-Oberflächenwellen-Absorber in einem Bereich benachbart zum IDT bildenden leitenden Widerstandsschicht (26,28) an der Substrat-Oberfläche.

11. SAW-Bauelement nach Anspruch 10, bei dem die den Akustik-Oberflächenwellen-Absorber bildende Schicht (26,28) und die Schicht (46) mit dem IDT (22,24) daran Schichten aus im wesentlichen dem gleichen Material mit gleicher Dicke sind.

12. SAW-Bauelement nach einem der Ansprüche 10 oder 11, bei dem die den Akustik-Oberflächenwellen-Absorber bildende Schicht (26,28) benachbart zum IDT-Umriß eine sich im wesentlichen linear verjüngende Kante besitzt.

13. SAW-Bauelement nach einem der Ansprüche 10 bis 12, bei dem die den Akustik-Oberflächenwellen-Absorber bildende Schicht (26,28) von der Nähe des IDT (22,24)-Umrisses zu einer Kante (40,42) des Substrats reicht.

14. SAW-Bauelement nach einem der Ansprüche 10 bis 13, bei dem jede Schicht eine amorphe Siliciumschicht umfaßt.

15. SAW-Bauelement nach einem der Ansprüche 10 bis 14, bei dem jede Schicht einen Schichtwiderstandswert von mindestens etwa 0,5 MΩ/Quadr. besitzt.

16. SAW-Bauelement nach einem der Ansprüche 10 bis 15, bei dem das Substratmaterial Lithium-Niobat ist.

FIG. 1

FIG. 2

FIG. 3

1. CLEAN LINbO$_3$ SUBSTRATE

2. SPUTTER 100Å SILICON FILM

3. APPLY PHOTO RESIST

4. DEFINE IDT PATTERNS AND DEVELOP

5. EVAPORATE 2000Å ALUMINUM

6. REMOVE RESIST

7. APPLY PHOTO RESIST

8. DEFINE ABSORBER PATTERNS AND DEVELOP

9. REMOVE EXPOSED SILICON FILM WITH PLASMA ETCH

10. REMOVE RESIST, CLEAN AND PACKAGE